# EUROPEAN PATENT APPLICATION

(11) **EP 3 432 131 A1**
(43) Date of publication of application: **23.01.2019**
(21) Application number: 17191487.2
(22) Date of filing: 15.09.2017
(51) Int. Cl.: G06F 3/06, H03M 7/30, G06F 11/14

(54) **STORAGE SYSTEM OF DISTRIBUTED DEDUPLICATION FOR INTERNET OF THINGS BACKUP IN DATA CENTER AND METHOD FOR ACHIEVING THE SAME**

(30) Priority: 18.07.2017 TW 106123947
(71) Applicant: ProphetStor Data Services, Inc., 403 Taichung (TW)
(72) Inventor: CHEN, Wen Shyen, Taichung (TW); HSIEH, Wen Chieh, Taichung (TW)
(74) Representative: Lang, Christian

(57) **Abstract**

A method for achieving distributed deduplication for a storage system for Internet Of Things (IOT) backup in a data center and associated storage system are provided. The system includes a number of storage units. Each storage unit includes a number of to-be-stored-destinations; a control unit, for controlling operations of the storage unit; and a distributed deduplication module, for providing or updating the deterministic function to the control unit and the edge component, and executing each step of the method in the control unit and/or the edge component.

## Description

### FIELD OF THE INVENTION

The present invention relates to a storage system for Internet Of Things (IOT) backup in data centers and an associated method. More particularly, the present invention relates to a storage system for IOT backup in data centers with distributed deduplication technology to off-load the deduplication processing efforts from storage system to edge components connected thereto, and to scatter the big deduplication table data in centralized storage system to all the storage units.

### BACKGROUND OF THE INVENTION

Data centers are where huge amount of digital data are stored for access. As time goes by, the same data may be packaged in different formats, e.g. a statistic chart embedded in an excel file or a word file, respectively. It occupies storage space for the same data and thus causes waste of storage space. On the other hand, for continuous data inputted from a single source, repeated data also lower performance of the data centers. This is quite often seen in a stream updating monitoring video that contains a number of continuous frames with one or more corners keeping still. This is not only another kind of waste of storage space, but also a bottleneck for data transmission in limited bandwidth network environments.

In order to settle the above issues, there are many deduplication methods available in the prior arts. A commonly seen method is to use a deduplication table (DDT) for a storage system in the data center. Conventionally, DDTs work as follows: chunking a file into blocks or variable-sized units; fingerprinting each block or variable-sized unit as cryptographically secure hash signature, e.g., SHA-1; and indexing the hash signatures with storage locations for identification and elimination of duplications. The DDT is usually kept in a RAM module for the storage system. The rule of thumb for DDT size calculation in The Z File System (ZFS) is every 1-TB data in the storage space needs around 5-GB size of RAM module for the DDT. Other file systems share pretty much the similar figure. For a ZB-level data center, the size of DDT would extend to 5 EB. It would become an unaffordable cost.

In view of the above, it is desired to have a method for effectively reducing the burden of DDT in the data centers. A system utilizing the method, which can reduce storage space by eliminating duplicate data while minimize transmission of redundant data in limited bandwidth network environments, is highly expected, especially when the requirements of IOT increase.

### SUMMARY OF THE INVENTION

This paragraph extracts and compiles some features of the present invention; other features will be disclosed in the follow-up paragraphs. It is intended to cover various modifications and similar arrangements included within the spirit and scope of the appended claims.

In order to settle the issues above, a method for achieving distributed deduplication for a storage system for IOT backup in a data center is provided. The method includes the steps of: a) providing a deterministic function to control units each for one storage unit in a storage system and an edge component linked to the storage system; b) dividing a To-Be-Backup Data (TBBD) in the edge component into a plurality of To-Be-Stored Chunks (TBSC) in premeditated size by the edge component; c) calculating a hash value for each TBSC by the deterministic function by the edge component; d) calculating a To-Be-Stored Destination (TBSD) for each TBSC by the deterministic function by the edge component; e) checking if one TBSC already exists at a corresponding TBSD by a control unit in the storage unit chosen by the deterministic function; f) transmitting the TBSC(s) to the corresponding TBSD(s) where no TBSC exists and the associated hash value(s) to the control unit(s); g) storing the TBSC(s) in the corresponding TBSD(s) and the hash value(s) in a storage unit(s) chosen by the deterministic function; and h) indexing the stored TBSC(s) with the corresponding hash value(s) and TBSD(s) to the edge component and the control unit(s) in the storage unit(s).

Preferably, the deterministic function may be driven by variables of hash values, resilience schemes, distribution rules for storage units, Quality of Service (QoS) policy or Service Level Agreement (SLA) policy. The method may further include after step (h) the steps of: i) checking if all stored TBSC(s) are kept in the corresponding TBSD(s) periodically by the control units in the corresponding storage units; and j) if the result of step (i) is no, restoring the lost stored TBSC(s). The method may also include between step (b) and step (c) a step of: b1) encoding the TBSCs to have a plurality of To-Be-Stored Parities (TBSP). The method may even further include between step (b) and step (e) the steps of: c1) calculating a hash value for each TBSP by the deterministic function by the edge component; and d1) calculating a TBSD for each TBSC and each TBSP by the deterministic function by the edge component.

The present invention also provides another method for achieving distributed deduplication for a storage system for IOT backup in a data center. The method includes the steps of: a) providing a deterministic function to control units each for one storage unit in a storage system and an edge component linked to the storage system; b) dividing a TBBD in the edge component into a plurality of TBSCs in premeditated size by the edge component; c) calculating a hash value for each TBSC by the deterministic function by the edge component; d) calculating a TBSD for each TBSC of N replicas of the TBBD by the deterministic function by the edge component; e) checking if the TBSCs of the first replica already exist at corresponding TBSDs by the control units; f) transmitting the TBSC(s) having no TBSC existing at its TBSD with associated TBSDs of the same TBSC(s) in other replica(s) to the corresponding TBSD(s) and the associated hash value(s) to the control unit(s); g) storing the TBSC(s) in the corresponding TBSD(s) and the hash value(s) in a storage unit(s) chosen by the deterministic function; h) replicating the TBSC(s) transmitted to the TBSD(s) of the same TBSC(s) in other replica(s); and i) indexing the stored TBSC(s) with the corresponding hash value(s) and TBSD(s) to the edge component and the control unit(s) in the storage unit(s).

Preferably, the deterministic function may be driven by variables of hash values, resilience schemes, distribution rules for storage units, QoS policy or SLA policy. The method may further include after step (h) the steps of: j) checking if all stored TBSC(s) are kept in the corresponding TBSD(s) periodically by the control units; and k) if the result of step (j) is no, making a new replica for the lost stored TBSC(s). The method may also include between step (b) and step (c) a step of: b1) encoding the TBSCs to have a plurality of TBSPs. The method may even further include between step (b) and step (e) the steps of: c1) calculating a hash value for each TBSP by the deterministic function by the edge component; and d1) calculating a TBSD for each TBSP by the deterministic function by the edge component.

According to the present invention, a storage system of distributed deduplication achieved by the method above for IOT backup in a data center is disclosed. The storage system may include: a number of storage units, each having a number of TBSDs; a control unit, for controlling operations of the storage unit; and a distributed deduplication module, for providing or updating the deterministic function to the control unit and the edge component, and executing each step of the method in the control unit and/or the edge component. Preferably, the distributed deduplication module may be hardware or software installed in the control unit.

### BRIEF DESCRIPTION OF THE DRAWINGS

Fig. 1 shows a scenario of application of a storage system of distributed deduplication for IOT backup in a data center and an infrastructure of the storage system according to the present invention.
Fig. 2 is a flowchart of a method for achieving distributed deduplication for a storage system for IOT backup in a data center.
Fig. 3 tabularizes all data used in this embodiment for the flowchart.
Fig. 4 tabularizes all data used in another embodiment.
Fig. 5 is a flowchart of another method for achieving distributed deduplication for a storage system for IOT backup in a data center.
Fig. 6 tabularizes all data used in one another embodiment for the flowchart.
Fig. 7 tabularizes all data used in still another embodiment.

### DETAILED DESCRIPTION OF THE PREFERRED EMBODIMENTS

The present invention will now be described more specifically with reference to the following embodiments.

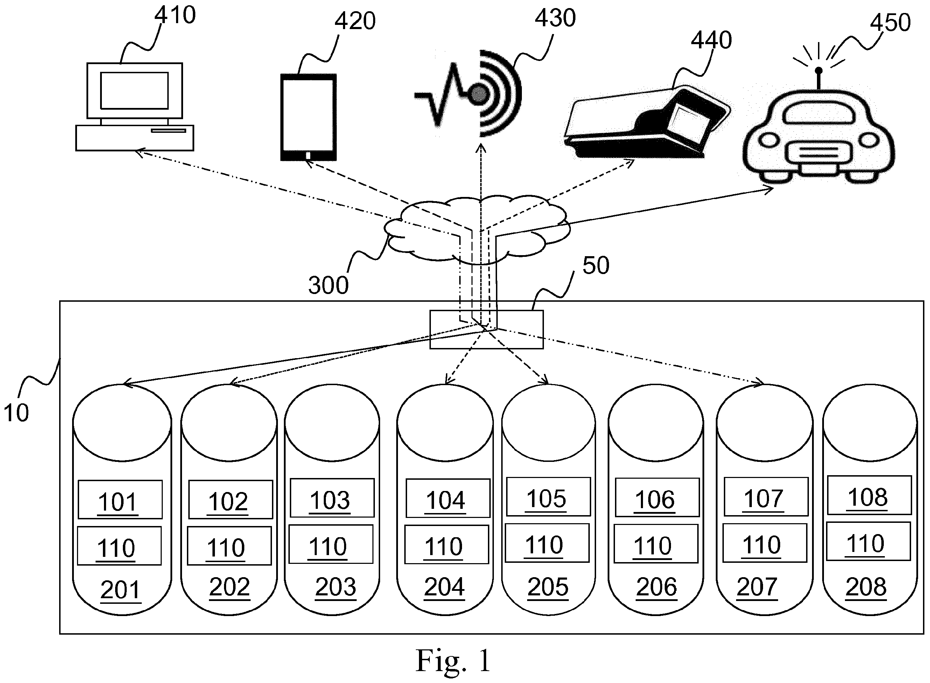

Please refer to Fig. 1. It shows a scenario of application of a storage system 10 of distributed deduplication for IOT backup in a data center and an infrastructure of the storage system 10 according to the present invention. The storage system 10 is basically composed of a number of storage units. All data in and out of the storage system 10 go through a host 50. The storage units may be, but not limited to, HDDs (Hard Disk Drive), SSDs (Solid State Disk), magnetic types or RAIDs (Redundant Array of Independent Disk). The number of storage units may be hundreds of thousands depending on the requirement the data center needs. In order to have a better understanding of the present invention, there are 8 storage units used for illustration (a first storage unit 201, a second storage unit 202, a third storage unit 203, a fourth storage unit 204, a fifth storage unit 205, a sixth storage unit 206, a seventh storage unit 207, and an eighth storage unit 208). Each storage unit has a number of TBSDs, such as blocks or volumes, which are used in later descriptions. Each storage unit also has a control unit (a first control unit 101 for the first storage unit 201, a second control unit 102 for the second storage unit 202, a third control unit 103 for the third storage unit 203, a fourth control unit 104 for the fourth storage unit 204, a fifth control unit 105 for the fifth storage unit 205, a sixth control unit 106 for the sixth storage unit 206, a seventh control unit 107 for the seventh storage unit 207, and an eighth control unit 108 for the eighth storage unit 208) to control operations of the storage unit. Different from current technologies, each storage unit according to the present invention further has a distributed deduplication module 110. The distributed deduplication module 110 can provide a deterministic function for the storage system 10, and is embedded in each storage unit. Meanwhile, the distributed deduplication module 110 is also embedded or installed in edge components linked to the storage system 10 (not shown in Fig. 1). If the deterministic function is changed with its factors, the change should be updated both to the distributed deduplication module 110 in each storage unit and that in all edge components. The deterministic function will be further illustrated later with methods for achieving distributed deduplication for the storage system 10. The storage system 10 can also execute each step of the methods in the control units and/or the edge component side. It is the key part of the present invention. In practice, the distributed deduplication module 110 may be hardware as shown in Fig. 1 to auxiliarily operate the storage system 10. It may also be software installed in the control units. It is not limited by the present invention.

The edge components are all devices or equipment linked to the storage system 10 over a network 300, embedded with electronics, software, sensors, actuators, and network connectivity that enable these edge components to collect and exchange data. The collected data need to be backed up in the data center (storage system 10) for further use or analysis. The edge components may be a personal computer 410 to upload homemade videos to share with others, a smart phone 420 using a social communication app to exchange messages with the help of the storage system 10, an embedded sensor 430 in a smart shirt to keep recording body temperature and store the data to the storage system 10 for analysis, a monitor 440 to watch crowds in a gate of a store and back up monitored video in the storage system 10, and a remote tracking device 450 installed in a rental car to trace the car. Each edge component represents a scenario of the application of the present invention. It is clear that no matter which application takes place, deduplication of data sent to the storage system 10 is necessary in case the storage system 10 will be occupied with redundant data soon. In the present invention, a new means, distributed deduplication, is provided. It means deduplication is no longer implemented by the storage system 10 (control units) only. Instead, the whole processes can be achieved by the storage system 10 and the edge components linked thereto. Loading of the storage system 10 can therefore be reduced. The methods for achieving distributed deduplication for the storage systems for IOT backup in a data center are disclosed below with detailed description of embodiments.

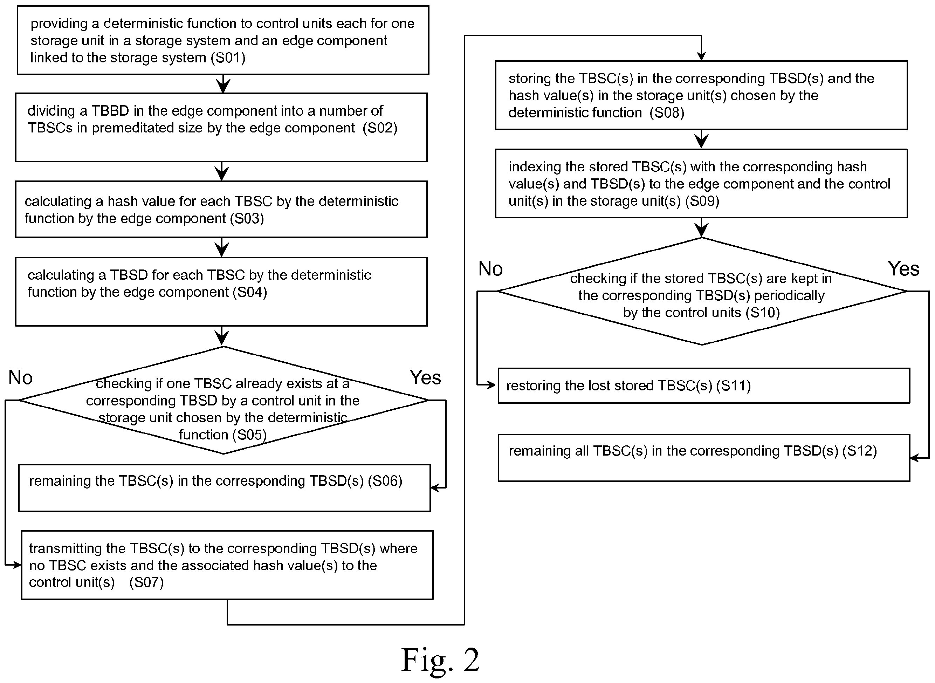

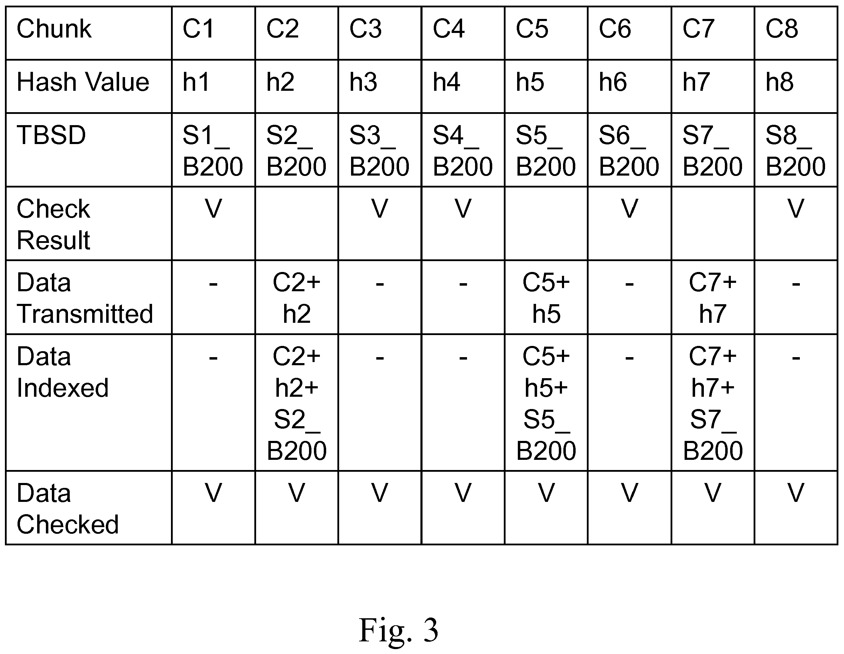

Assume a user uses the personal computer 410 to upload his video to the storage system 10 where a workload of video sharing runs to share the video to whom are interested in. The video contains some fragments that come from movie clips and the movie clips may already leave a backup in a storage unit of the storage system 10. In order to deduplicate these fragments and save storage space, the method provided by the present invention can be applied. Please see Fig. 2 and Fig. 3 with below description. Fig. 2 is a flowchart of the method and Fig. 3 tabularizes all data used in this embodiment for the flowchart. Based on the architecture of the storage system 10 and the edge components in Fig. 1, the first step of the method is providing a deterministic function to each control unit (101 to 108) of the storage unit (201 to 208) in the storage system 10 and the personal computer 410 linked to the storage system 10 (S01). The deterministic function is driven by variables of resilience schemes, distribution rules for storage units, Quality of Service (QoS) policy and/or Service Level Agreement (SLA) policy so that it can determine a TBSD for each TBSC (will be described later). It is to say when certain 'variables' are inputted, a corresponding TBSD can be obtained (calculated). For example, the hash value comes from one TBSC, the resilience scheme asks of the restoring time not exceeding 200ms, the distribution rule for storage units requires all TBSCs from one backup data can not be located in one storage unit (should be separated), and QoS and SLA both request latency for the video downloading should be within 3 seconds. Thus, the TBSD can be determined. It should be noticed that the variables mentioned above are just for illustrative purpose and should not be considered as the only variables. Other factors which can be used to properly assign a TBSD can be applied. The deterministic function is provided by the distributed deduplication module 110. The deterministic function may come with some codes as a program installed in the control units and in the personal computer 410. When the personal computer 410 is linked to the storage system 10, the program becomes active and the deterministic function is available for distributed deduplication.

The second step of the method is dividing a TBBD in the personal computer 410 into a number of TBSCs in premeditated size by the personal computer 410 (S02). The TBBD is the video file in this case. Take the premeditated size as 512 Kbits as a size of a block in a storage unit. Suppose the video file is 4000 Kbits in size. There are 8 TBSCs (C1 to C8 shown in the first row of the table in Fig. 3). The eighth doesn't have 512 Kbits of effective bits. Therefore, it can be padded with '0' for the last 96 Kbits. As some deduplication efforts have been distributed to edge components, step S02 is emphasized to be processed by the personal computer 410 although the control units have installed the deterministic function. Next, calculate a hash value for each TBSC by the deterministic function by the personal computer 410 (S03). Again, a local calculation is done in the personal computer 410. Corresponding hash values for the chunks are shown in the second row of the table in Fig. 3, from h1 to h8. There are many existing methods, such as SHA-1, to get the hash values for data images (fingerprinting), it is not restricted by the present invention. Generally speaking, a unique TBSC corresponds to a specific hash value.

A following step is to calculate a TBSD for each TBSC by the deterministic function by the personal computer 410 (S04). Please see Fig. 3. In this embodiment, the TBSDs for the chunks are block 200 of storage unit 201 (S1_B200) for C1, block 200 of storage unit 202 (S2_B200) for C2, block 200 of storage unit 203 (S3_B200) for C3, block 200 of storage unit 204 (S4_B200) for C4, block 200 of storage unit 205 (S5_B200) for C5, block 200 of storage unit 206 (S6_B200) for C6, block 200 of storage unit 207 (S7_B200) for C7, and block 200 of storage unit 208 (S8_B200) for C8. Now, it needs to check if one TBSC already exists at a corresponding TBSD by a control unit in the storage unit chosen by the deterministic function (S05). This job should be executed by each control unit in the storage unit, which receives the request from the edge components. From the table in Fig. 3, TBSDs for C1, C3, C4, C6, and C8 are already in the storage system 10. It means there might be 5 fragments of the video are redundant for the storage system 10 so that the storage system 10 has them. The TBSDs for C2, C5 and C7 are available for the corresponding TBSCs. According to the check result, if it is yes, keep the TBSC(s) in the corresponding TBSD(s) (S06); if it is no, transmit the TBSC(s) to the corresponding TBSD(s) where no TBSC exists and the associated hash value(s) to the respective control units(s) (S07). The control units should have all hash values for all TBSCs in corresponding storage units. However, under this situation, only new TBSC(s) with their hash value(s) are required to be kept by the control unit(s) of the storage system 10.

Next, store the TBSC(s) in the corresponding TBSD(s) and the hash value(s) in the storage unit(s) chosen by the deterministic function (S08). In step S08, the locations of the hash values are not assigned by any specific rules. It depends on the operation of deterministic function to find suitable locations. As illustrated above, the storage unit includes many TBSDs. The TBSD is a minimum storage element reserved for a TBSC, while the storage unit is simply used to keep the hash value(s) no matter which TBSDs are assigned to do the job.

A following step is indexing the stored TBSC(s) with the corresponding hash value(s) and TBSD(s) to the personal computer 410 and the control unit(s) in the storage unit(s) (S09). This step means since a new TBSC is stored to the corresponding TBSD, the corresponding hash value and TBSD should be acknowledged by all parties. The indexes may be kept in the control units or some TBSDs in the storage units of the storage system 10, and a sand box in a memory or a storage of the personal computer 410. From Fig. 3, it is clear that C2+h2+S2_B200, C5+h5+S5_B200, and C7+h7+S7_B200 are indexed.

The final step is to check if all stored TBSC(s) are kept in the corresponding TBSD(s) periodically by the control units (S10). For some reasons, e.g. one stored TBSD been carelessly deleted, the stored TBSC is lost. The lost TBSC needs to be restored to keep the system synced up and consistent. So, if there is any stored TBSC(s) found lost, just restore the lost stored TBSC(s) (S11). This can be done with the indexed hash value to reverse derivate. If there is no stored TBSC(s) found lost, remain all TBSC(s) in the corresponding TBSD(s) (S12). Step S10 processes again and again to ensure no stored TBSC backed up in the storage system 10 will be gone.

In the above embodiment, it shows the method for general TBBD. According to the spirit of the present invention, there is another method for the general TBBD with its parities for error check. Below is another embodiment for this method.

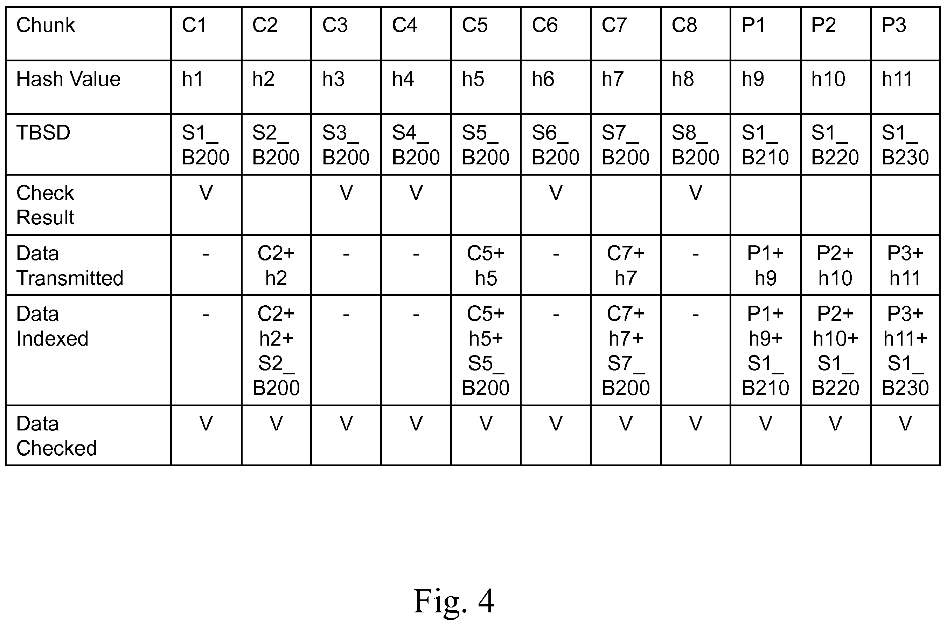

Please refer to Fig. 2 and Fig. 4. Fig. 4 tabularizes all data used in another embodiment. The new method and the previous method have some steps in common. There are two different points. First, a step, S02', exists between the step S02 and S03. S02' states that encode the TBSCs to have a number of TBSPs. Size of the TBSP should be the same as that of the TBSC. 0 can be used for padding. As shown in Fig. 4, there are three TBSPs, P1, P2, and P3. The second different point is there are two more steps inserted between step S02 and step S05. They are calculating a hash value for each TBSP by the deterministic function by the personal computer 410 (S03'), and calculating a TBSD for each TBSP by the deterministic function by the personal computer 410 (S04'). Sequence of step S03' and S04' is not limited by that of step S03 and S04. It is because the method can process for all TBSCs prior to all TBSPs. The method can also deal with all hash values first and all TBSDs later. As well, since TBSCs and TBSPs are available after step S02', all TBSPs may be processed first and all TBSCs may be processed later. The rest steps are the same.

From Fig. 4, the hash values for P1, P2, and P3 are h9, h10, and h11, respectively. The TBSDs for P1, P2, and P3 are block 210 of storage unit 1 (S1_B210) for P1, block 220 of storage unit 1 (S1_B220) for P2, block 230 of storage unit 1 (S1_B230) for P3. After step S05, all the three TBSDs are empty. Thus, P1+h9, P2+h10, and P3+h11 are transmitted and stored by the control units. Finally, P1+h9+ S1_B210, P2+h10+ S1_B220, and P3+h11+ S1_B230 are indexed. Step S10 repeats to monitor if any TBSC or TBSP is lost.

The above two embodiments apply when no replica is required. For safety reason, some data need replicas. Since data transmitted and spaces for storage are large, for this situation, the present invention provides other methods to deal with. Two more embodiments below are used to introduce associated methods.

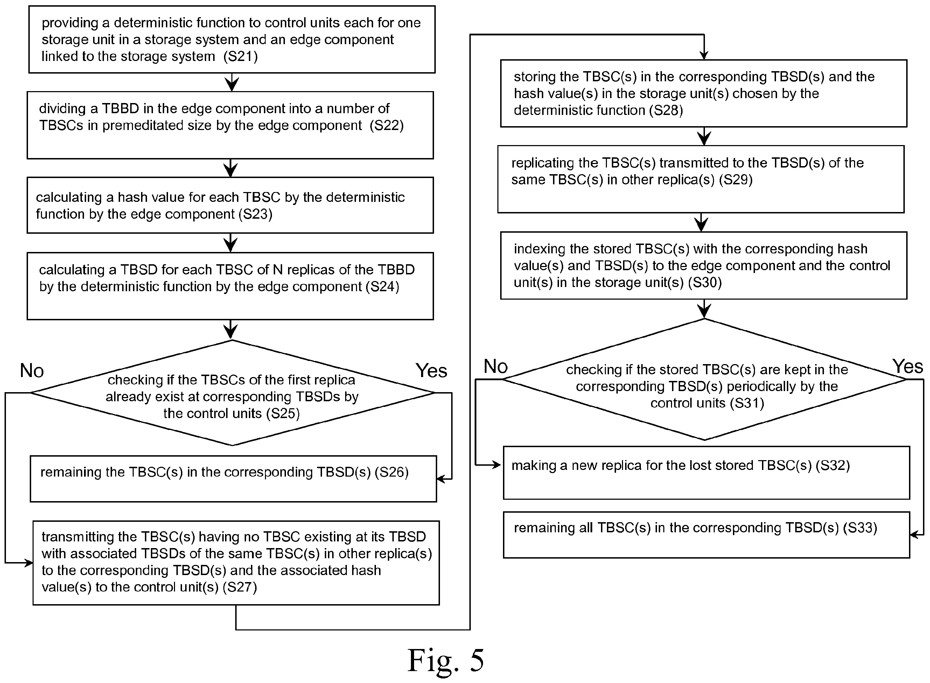

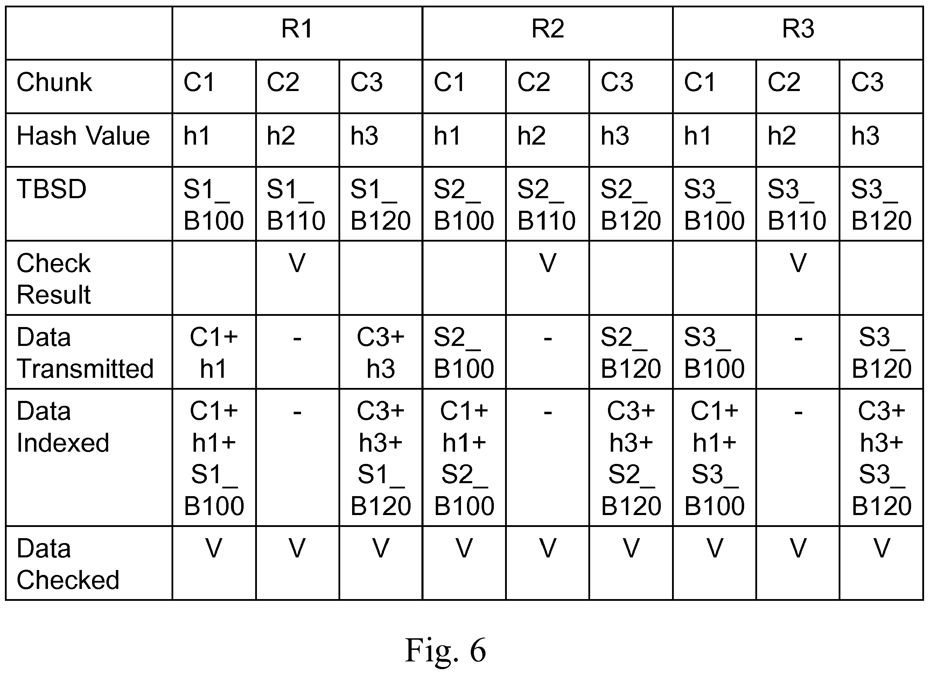

Assume the embedded sensor 430 keeps sending body temperature and related messages to the storage system 10 for analysis. For a healthy body, the information should remain stable with time. Thus, there might be many data unchanged during a period of time. This is a good example for applying the method of the present invention. Please see Fig. 5 and Fig. 6 with below description. Fig. 5 is a flowchart of the method and Fig. 6 tabularizes all data used in this embodiment for the flowchart. Based on the architecture of the storage system 10 and the edge components in Fig. 1, the first step of the method is providing the deterministic function to the control units each for a storage unit in the storage system 10 and the embedded sensor 430 linked to the storage system 10 (S21). The second step is dividing a TBBD in the embedded sensor 430 into a number of TBSCs in premeditated size by the embedded sensor 430 (S22). The third step is calculating a hash value for each TBSC by the deterministic function by the embedded sensor 430 (S23). There is no significant difference between step S01 to S03 and S21 to S23. The only difference would be the size of the TBSC. Since the body temperature and related data with time are digital data and not huge, in order to have a better effect of deduplication, the size of TBSC can be 16K bits or less. It means it is not a block size and several TBSCs can be combined to fill in a block.

The next step is calculating a TBSD for each TBSC of N replicas of the TBBD by the deterministic function by the embedded sensor 430 (S24). N is a positive integer. It means the method can work for any number of replicas. In this embodiment, N is 3. Please refer to Fig. 6. Three replicas all have three TBSCs, C1, C2, and C3, respectively. Hash values for all TBSCs are the same. They are h1, h2, and h3. However, the corresponding TBSDs for the TBSCs of the replicas are different. This is a specific design of the deterministic function: even the same data are with identical hash values, they will be replicated to different location. In this embodiment, C1 of a first replica (R1) is assigned to block 100 of the storage unit 201 (S1_B100), C2 of the first replica is assigned to block 110 of the storage unit 201 (S1_B110), C3 of the first replica is assigned to block 120 of the storage unit 201 (S1_B120), C1 of a second replica (R2) is assigned to block 100 of the storage unit 202 (S2_B100), C2 of the second replica is assigned to block 110 of the storage unit 202 (S2_B110), C3 of the second replica is assigned to block 120 of the storage unit 202 (S2_B120), C1 of a third replica (R3) is assigned to block 100 of the storage unit 203 (S3_B100), C2 of the third replica is assigned to block 110 of the storage unit 203 (S3_B110), and C3 of the third replica is assigned to block 120 of the storage unit 203 (S3_B120).

The following step is checking if the TBSCs of the first replica already exist at corresponding TBSDs by the control units (S25). If the answer is yes, remain the TBSC(s) in the corresponding TBSD(s) (S26); if the answer is no, transmit the TBSC(s) having no TBSC existing at its TBSD with associated TBSDs of the same TBSC(s) in other replica(s) to the corresponding TBSD(s) and the associated hash value(s) to the control unit(s) (S27). For a better understanding, please come back to Fig. 6. Following step S25, it is found that there is already a C2 in S1_B110. Therefore, C2 leaves as it is (step S26). For C1 and C2 of R1 are transmitted to S1_B100 and S1_B120, respectively. C1 is transmitted with h1 and C3 is transmitted with h3. Meanwhile, the TBSDs of C1 and C3 in R2 and R3 are all transmitted to the control units (step S27). The next step is storing the TBSC(s) in the corresponding TBSD(s) and the hash value(s) in the storage unit(s) chosen by the deterministic function (S28). At this stage, all TBSCs of the first replica have been backed up in corresponding TBSDs while the rest replicas are not ready. Like the previous embodiment, the hash values, h1, h2, and h3 are kept by the control units.

The next step is replicating the TBSC(s) transmitted to the TBSD(s) of the same TBSC(s) in other replica(s) (S29). Intuitively, this step is to make extra two replicas. However, it is not the same as a commonly applied replication. The locations, TBSDs, have already determined by the deterministic function. Next, index the stored TBSC(s) with the corresponding hash value(s) and TBSD(s) to the edge component and the control unit(s) (S30). It should be emphasized that in this embodiment, indexing is for all three sets of TBSCs of the replicas, not only for the first replica. Data indexed are shown in Fig. 6 and it is not to repeat it again.

A final step is checking if the all stored TBSC(s) are kept in the corresponding TBSD(s) periodically by the control units (S31). The purpose of step S31 is the same as that of step S10 in the previous embodiments. The lost TBSC needs to be restored. So, if there is any stored TBSC(s) found lost, make a new replica for the lost stored TBSC(s) (S32). If there is no stored TBSC(s) found lost, remain all TBSC(s) in the corresponding TBSD(s) (S33). Step S31 processes again and again to ensure no stored TBSC of the three replicas in the storage system 10 will be vanished.

Similarly, in the above embodiment, it shows the method for general TBBD in several replicas. According to the spirit of the present invention, there is another method for the general TBBD with its parities for error check and one replica for safety reasons. Below is another embodiment for this method.

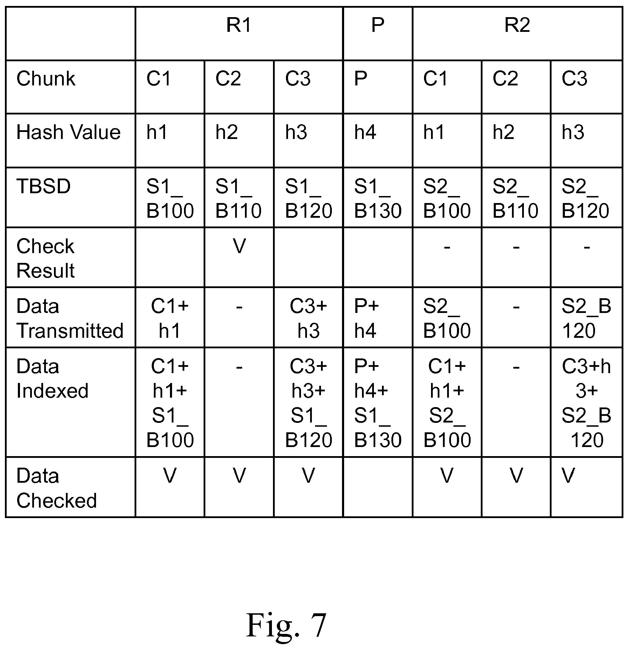

Please refer to Fig. 5 and Fig. 7. Fig. 7 tabularizes all data used in another embodiment. The new method and the previous method have some steps in common. There are two different points. First, a step, S22', exists between the step S22 and S23. S22' states that encode the TBSCs to have a plurality of TBSPs. Size of the TBSP should be the same as that of the TBSC. 0 can be used for padding. In this embodiment, there is only one TBSP. The TBSP, P, comes with a hash value h4. The second different point is there are two more steps inserted between step S22 and step S25. They are calculating a hash value for each TBSP by the deterministic function by the embedded sensor 430 (S23'), and calculating a TBSD for each TBSP and one replica of the TBBD by the deterministic function by the embedded sensor 430 (S24'). Sequence of step S23' and S24' is not limited by that of step S23 and S24. It is because the method can process for all TBSCs prior to all TBSPs and one replica. The method can also deal with all hash values first, and all TBSDs and one replica later. Since TBSCs and TBSPs are available after step S22', all TBSPs and one replica may be processed first and all TBSCs processed later. The rest steps are the same.

While the invention has been described in terms of what is presently considered to be the most practical and preferred embodiments, it is to be understood that the invention needs not be limited to the disclosed embodiments. On the contrary, it is intended to cover various modifications and similar arrangements included within the spirit and scope of the appended claims, which are to be accorded with the broadest interpretation so as to encompass all such modifications and similar structures.

## Claims

1. A method for achieving distributed deduplication for a storage system for Internet Of Things (IOT) backup in a data center, comprising the steps of:
a) providing a deterministic function to control units each for one storage unit in a storage system and an edge component linked to the storage system;
b) dividing a To-Be-Backup Data (TBBD) in the edge component into a plurality of To-Be-Stored Chunks (TBSC) in premeditated size by the edge component;
c) calculating a hash value for each TBSC by the deterministic function by the edge component;
d) calculating a To-Be-Stored Destination (TBSD) for each TBSC by the deterministic function by the edge component;
e) checking if one TBSC already exists at a corresponding TBSD by a control unit in the storage unit chosen by the deterministic function;
f) transmitting the TBSC(s) to the corresponding TBSD(s) where no TBSC exists and the associated hash value(s) to the control unit(s);
g) storing the TBSC(s) in the corresponding TBSD(s) and the hash value(s) in the storage unit(s) chosen by the deterministic function; and
h) indexing the stored TBSC(s) with the corresponding hash value(s) and TBSD(s) to the edge component and the control unit(s) in the storage unit(s).

2. The method according to claim 1, wherein the deterministic function is driven by variables of hash values, resilience schemes, distribution rules for storage units, Quality of Service (QoS) policy or Service Level Agreement (SLA) policy.

3. The method according to claim 1, further comprising after step (h) the steps of:
i) checking if all stored TBSC(s) are kept in the corresponding TBSD(s) periodically by the control units in the corresponding storage units; and
j) if the result of step (i) is no, restoring the lost stored TBSC(s).

4. The method according to claim 1, further comprising between step (b) and step (c) a step of:
b1) encoding the TBSCs to have a plurality of To-Be-Stored Parities (TBSP).

5. The method according to claim 4, further comprising between step (b) and step (e) the steps of:
c1) calculating a hash value for each TBSP by the deterministic function by the edge component; and
d1) calculating a TBSD for each TBSP by the deterministic function by the edge component.

6. A method for achieving distributed deduplication for a storage system for IOT backup in a data center, comprising the steps of:
a) providing a deterministic function to control units each for one storage unit in a storage system and an edge component linked to the storage system;
b) dividing a TBBD in the edge component into a plurality of TBSCs in premeditated size by the edge component;
c) calculating a hash value for each TBSC by the deterministic function by the edge component;
d) calculating a TBSD for each TBSC of N replicas of the TBBD by the deterministic function by the edge component;
e) checking if the TBSCs of the first replica already exist at corresponding TBSDs by the control units;
f) transmitting the TBSC(s) having no TBSC existing at its TBSD with associated TBSDs of the same TBSC(s) in other replica(s) to the corresponding TBSD(s) and the associated hash value(s) to the control unit(s);
g) storing the TBSC(s) in the corresponding TBSD(s) and the hash value(s) in the storage unit(s) chosen by the deterministic function;
h) replicating the TBSC(s) transmitted to the TBSD(s) of the same TBSC(s) in other replica(s); and
i) indexing the stored TBSC(s) with the corresponding hash value(s) and TBSD(s) to the edge component and the control unit(s) in the storage unit(s).

7. The method according to claim 6, wherein the deterministic function is driven by variables of hash values, resilience schemes, distribution rules for storage units, QoS policy or SLA policy.

8. The method according to claim 6, further comprising after step (h) the steps of:
j) checking if all stored TBSC(s) are kept in the corresponding TBSD(s) periodically by the control units in the corresponding storage units; and
k) if the result of step (j) is no, making a new replica for the lost stored TBSC(s).

9. The method according to claim 6, further comprising between step (b) and step (c) a step of:
b1) encoding the TBSCs to have a plurality of TBSPs.

10. The method according to claim 9, further comprising between step (b) and step (e) the steps of:
c1) calculating a hash value for each TBSP by the deterministic function by the edge component; and
d1) calculating a TBSD for each TBSP by the deterministic function by the edge component.

11. A storage system of distributed deduplication achieved by the method according to any one of claims 1-10 for IOT backup in a data center comprising a plurality of storage units, **characterized in that** each storage unit comprises:
a plurality of TBSDs;
a control unit, for controlling operations of the storage unit; and
a distributed deduplication module, for providing or updating the deterministic function to the control unit and the edge component, and executing each step of the method in the control unit and/or the edge component.

12. The storage system according to claim 11, wherein the distributed deduplication module is hardware or software installed in the control unit.
